# EUROPEAN PATENT SPECIFICATION

(11) **EP 0 929 842 B1**
(45) Date of publication and mention of the grant of the patent: **21.03.2001**
(21) Application number: 97910365.2
(22) Date of filing: 26.09.1997
(51) Int. Cl.: G03F 7/09, C09B 29/32

(54) **BOTTOM ANTIREFLECTIVE COATINGS CONTAINING AN ARYLHYDRAZO DYE**
ANTIREFLEXIONS-UNTERSCHICHTEN MIT ARYLHYDRAZO FARBSTOFF
REVETEMENTS DE FOND ANTIREFLECHISSANTS CONTENANT UN COLORANT ARYLHYDRAZO

(30) Priority: 30.09.1996 US 724126
(43) Date of publication of application: 21.07.1999
(73) Proprietor: Clariant Finance (BVI) Limited, Road Town, Tortola (VG)
(72) Inventor: DING, Shuji, Somerville, NJ 08876 (US); CORSO, Anthony, J., Flemington, NJ 08822 (US); KHANNA, Dinesh, N., Flemington, NJ 08822 (US); HANNIGAN, Timothy, T., Basking Ridge, NJ 07920 (US); EBERLY, Daniel, E., Randolph, NJ 07869 (US); LU, Ping-Hung, Bridgewater, NJ 08807 (US)
(74) Representative: Hütter, Klaus, Dr.
(86) International application number: EP9705279
(87) International publication number: WO9814832

(56) References cited:
- US-A- 4 497 735
- US-A- 5 100 760
- PATENT ABSTRACTS OF JAPAN vol. 012, no. 427 (P-784), 11 November 1988 & JP 63 159858 A (KONICA CORP), 2 July 1988,
- STURTEVANT J ET AL: "ANTIREFLECTION STRATEGIES FOR ADVANCED PHOTOLITHOGRAPHY" MICROLITHOGRAPHY WORLD, vol. 4, no. 4, 21 September 1995, pages 13-15, 18 - 21, XP000535370

## Description

### Background of Invention

The present invention relates to a novel antireflective coating solution comprising a polymer, a solvent and a novel dye. The dye of this invention has good absorption characteristics, good solubility and good lithographic characteristics. The invention further comprises a process for coating a substrate with the novel antireflective coating and imaging a photoresist film coated on top of the antireflective film.

Photoresist compositions are used in microlithography processes for making miniaturized electronic components such as in the fabrication of computer chips and integrated circuits. Generally, in these processes, a thin coating of film of a photoresist composition is first applied to a substrate material, such as silicon wafers used for making integrated circuits. The coated substrate is then baked to evaporate any solvent in the photoresist composition and to fix the coating onto the substrate. The baked coated surface of the substrate is next subjected to an image-wise exposure to radiation.

This radiation exposure causes a chemical transformation in the exposed areas of the coated surface. Visible light, ultraviolet (UV) light, electron beam and X-ray radiant energy are radiation types commonly used today in microlithographic processes. After this image-wise exposure, the coated substrate is treated with a developer solution to dissolve and remove either the radiation-exposed or the unexposed areas of the photoresist.

The trend towards the miniaturization of semiconductor devices has lead to the use of sophisticated multilevel systems to overcome difficulties associated with such miniaturization. The use of highly absorbing antireflective coatings in photolithography is a simpler approach to diminish the problems that result from back reflection of light from highly reflective substrates. Two deleterious effects of back reflectivity are thin film interference and reflective notching. Thin film interference results in changes in critical linewidth dimensions caused by variations in the total light intensity in the resist film as the thickness of the resist changes. Variations of linewidth are proportional to the swing ratio (S) and therefore must be minimized for better linewidth control. Swing ratio is defined by:

S = 4(R₁R₂)^{1/2}e^{-αD}

where R₁ is the reflectivity at the resist/air or resist/top coat interface,
where R₂ is the reflectivity at the resist/substrate interface,
where α the resist optical absorption coefficient, and
D is the film thickness.

Antireflective coatings function by absorbing the radiation used for exposing the photoresist, that is, reducing R₂ and thereby reducing the swing ratio. Reflective notching becomes severe as the photoresist is patterned over substrates containing topographical features, which scatter light through the photoresist film, leading to linewidth variations, and in the extreme case, forming regions with complete resist loss.

In the past dyed photoresists have been utilized to solve these reflectivity problems. However, it is generally known that dyed resists only reduce reflectivity from the substrate but do not totally eliminate it. In addition, dyed resists also cause reduction in the lithographic performance of the photoresist, together with possible sublimation of the dye and incompatibility of the dye in resist films. In cases where further reduction or elimination of the swing ratio is required, an antireflective coating is applied prior to coating with the photoresist and prior to exposure. The resist is exposed imagewise and developed. The antireflective coating in the exposed area is then etched, typically in an oxygen plasma, and the resist pattern is thus transferred to the substrate. The etch rate of the antireflective film should be relatively high so that the antireflective film is etched without excessive loss of the resist film during the etch process.

Polymeric organic antireflective coatings are known in the art as described in EP 583,205 and US 5,525,457. However, these antireflective films are cast from organic solvents, such as cyclohexanone and cyclopentanone. The potential hazards of working with organic solvents, have lead to the development of the antireflective coating composition of the instant invention, where the solid components of the antireflective coating are both soluble and spin castable from solvents having lesser toxicity hazards. The preferred solvents that are known in the semiconductor industry to have low toxicity among others are propylene gycol monomethyl etheracetate (PGMEA), propylene gycol monomethylether (PGME), and ethyl lactate.

### Summary of the Invention

The present invention relates to a novel antireflective coating composition and a process for its use in photolithography. The antireflective composition comprises a polymer, a solvent and a dye of the structure, 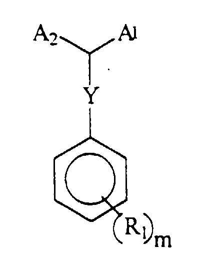 where
A₁ and A₂ are independently COR₁, CN or CNZ,
R₁ is H, (C₁-C₁₀)alkyl, (C₁-C₁₀)alkoxy, nitro, halide, cyano, aryl, alkylaryl, alkenyl, dicyanovinyl, SO₂CF_{3,} COOZ, SO₃Z, COZ, OZ, NZ₂, SZ, SO₂Z,
NHCOZ or SO₂NZ₂, where Z is H or (C₁-C₁₀)alkyl,
Y is a conjugated moiety e.g. N=N, CW=CW, CW=N, or N=CW, where W is H, (C₁-C₁₀)alkyl or (C₁-C₁₀)alkoxy, and
m = 5.

The more preferred structure for the dye is, 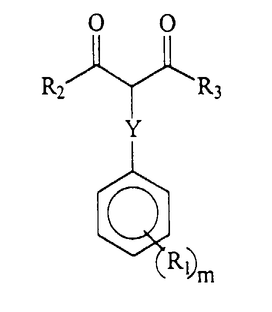 where
R₁-R₃ are independently H, (C₁-C₁₀)alkyl, (C₁-C₁₀)alkoxy, nitro, halide, cyano, aryl, alkylaryl, alkenyl, dicyanovinyl, SO₂CF₃, COOZ, SO₃Z, COZ, OZ, NZ₂, SZ, SO₂Z, NHCOZ or SO₂NZ₂, where Z is H or (C₁-C₁₀)alkyl,
Y is a conjugated moiety e.g. N=N, CW=CW, CW=N, or N=CW, where W is H, (C₁-C₁₀)alkyl or (C₁-C₁₀)alkoxy, and
m = 5.

The dye of this invention has very good absorption characteristics, good solubility and gives good lithographic performance.

### Detailed Description of the Invention

The present invention relates to a novel antireflective coating composition and a process for its use in photolithography. The antireflective composition comprises a polymer, a solvent and a dye of the structure, 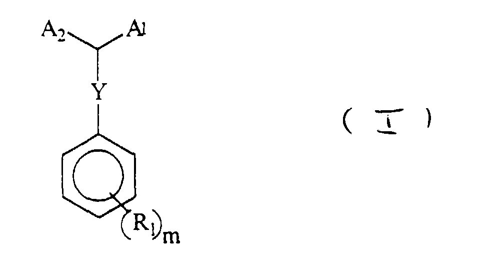 where
A₁ and A₂ are independently an electronwithdrawing group, preferrably COR₁, CN or CNZ,
R₁ is H, (C₁-C₁₀)alkyl, (C₁-C₁₀)alkoxy, nitro, halide, cyano, aryl, alkylaryl, alkenyl, dicyanovinyl, SO₂CF_{3,} COOZ, SO₃Z, COZ, OZ, NZ₂, SZ, SO₂Z, NHCOZ or SO₂, NZ₂, where Z is H or (C₁-C₁₀)alkyl,
Y is a conjugated moiety e.g. N=N, CW=CW, CW=N, or N=CW, where W is H, (C₁-C₁₀)alkyl or (C₁-C₁₀)alkoxy, and
m = 5.

The more preferred structure for the dye is, 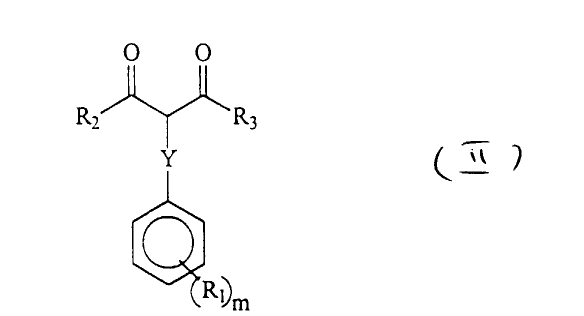 where
R₁-R₃ are independently H, (C₁-C₁₀)alkyl, (C₁-C₁₀)alkoxy, nitro, halide, cyano, aryl, alkylaryl, alkenyl, dicyanovinyl, SO₂CF₃, COOZ, SO₃Z, COZ, OZ, NZ₂, SZ, SO₂Z, NHCOZ or SO₂NZ₂, where Z is H or (C₁-C₁₀)alkyl,
Y is a conjugated moiety e.g. N=N, CW=CW, CW=N, or N=CW, where W is H, (C₁-C₁₀)alkyl or (C₁-C₁₀)alkoxy, and
m = 5.

The dye of this invention has very good absorption characteristics, that is, high extinction coefficient, good solubility and gives good lithographic performance. The higher the extinction coefficient for the dye, the more effective the dye is in reducing reflection of light from highly reflective substrates.

The polymer of the antireflective coating is used essentially as a binder resin to give good coating properties. The polymer can be any of the following, but is not limited to these, homo- and co-polymers of acrylates, amides, esters, ether, hydroxystryrene, imides, methacrylates, methyl vinyl ether-maleic anhydride, oxymethylenes, styrene, oxyalkylenes, urethanes, vinyl acetates, and vinyl ether, phenolic resins, epoxy resins, and novolak resins.

The solvent can be a single solvent or mixtures of solvents that dissolve the solid compounds of the antireflective composition and give good coating properties. The antireflective coating utilized in this invention may be dissolved in various solvents (hereafter referred to as casting solvent) to provide a composition which is useful for forming thin films. The solvent is selected from the group consisting of butyrolactone, cyclopentanone, cyclohexanone, dimethyl acetamide, dimethylformamide, dimethyl sulfoxide, N-methyl pyrrolidone, tetrahydrofurfural alcohol, propylene glycol monomethyl ether(PGME), propylene glycol monomethyl etheracetate(PGMEA), ethyl lactate, or combinations thereof, but PGME, PGMEA and ethyl lactate or mixtures thereof are preferred. Solvents with a lower degree of toxicity, and good coating and solubility properties are generally preferred.

The antireflective coating composition comprises a polymer, the dye of the instant invention and a suitable solvent or mixtures of solvents. Other components may be added to enhance the performance of the coating, e.g. monomeric crosslinking agents, monomeric dyes, lower alcohols, additives to promote crosslinking, surface levelling agents, adhesion promoters, antifoaming agents etc. Additives may be incorporated into the antireflective composition to improve a particular performance characteristic. Additives that induce crosslinking in the film at temperatures greater than about 70°C may be added. Such additives may be crosslinking agents, such as, crosslinking agents which are effective to crosslink hydroxy, amide, carboxyl, and thiol functional polymers are applicable in the current inventions. Examples of such crosslinking agents are hydroxy or alkoxymethylmelamines, urea-formaldehyde resins, benzyl ethers or alcohols, epoxy compounds, isocyanates or blocked equivalents, and alkylol acrylamides or methacrylamides. Further additives may also be added that increase the efficiency of crosslinking, for example, acids, in particular thermally generated acids, such as essentially 2,1,4 diazonaphthoquinone eaters of phenolic compounds.

It is desireable to have an antireflective coating that after baking is not soluble in the casting solvent of the photoresist and additionally is not deteriorated by the aqueous alkaline developer used to develop the photoresist.

The absorption of the antireflective coating can be optimized for a certain wavelength or ranges of wavelengths by the suitable choice of substituents on the dye. Using substituents that are electron-withdrawing or electron donating generally shifts the absorption wavelength to longer or shorter wavelengths respectively. In addition, the solubility of the dye in a particularily preferred solvent can be adjusted by the appropriate choice of substituents on the monomer.

In another embodiment the substituents in the dye that are hydrophilic in nature might be chosen such that the dye is then water soluble. In such instances a water soluble polymer and a water soluble dye could be dissolved in water to give a aqueous based bottom antireflective coating.

The polymer of the antireflective coating composition is present in the range of about 1% to about 30% by total weight of solution. The exact weight used is dependent on the molecular weight of the polymer and the film thickness of the coating desired. The dye is present at a level from about 0.25% by weight to about 20% by weight of the solution.

Since the antireflective film is coated on top of the substrate and is further subject to dry etching it is envisoned that the film is of sufficiently low metal ion level and purity that the properties of the semiconductor device are not adversely effected. Treatments such as passing a solution of the polymer or the dye through an ion exchange column, filteration, and an extraction process can be used to reduce the concentration of metal ions and to reduce particles.

The antireflective coating composition is coated on the substrate using techniques well known to those skilled in the art, such as dipping, spincoating or spraying. The film thickness of the antireflective coating ranges from about 0.1 micron to about 1 micron. The coating is further heated on a hot plate or convection oven to remove any residual solvent and to induce the appropriate degree of crosslinking, if a crosslinking additive is incorporated in the antireflective solution, in order to insolubilize the film.

Photoresists coated over the antireflective film can be any of the types used in the semiconductor industry provided the sensitivity of the photoactive compound in the photoresist matches that of the antireflective coating.

There are two types of photoresist compositions, negative-working and positive-working. When negative-working photoresist compositions are exposed image-wise to radiation, the areas of the resist composition exposed to the radiation become less soluble to a developer solution (e.g. a cross-linking reaction occurs) while the unexposed areas of the photoresist coating remain relatively soluble to such a solution. Thus, treatment of an exposed negative-working resist with a developer causes removal of the non-exposed areas of the photoresist coating and the creation of a negative image in the coating. Thereby uncovering a desired portion of the underlying substrate surface on which the photoresist composition was deposited.

On the other hand, when positive-working photoresist compositions are exposed image-wise to radiation, those areas of the photoresist composition exposed to the radiation become more soluble to the developer solution (e.g. a rearrangement reaction occurs) while those areas not exposed remain relatively insoluble to the developer solution. Thus, treatment of an exposed positive-working photoresist with the developer causes removal of the exposed areas of the coating and the creation of a positive image in the photoresist coating. Again, a desired portion of the underlying surface is uncovered.

Positive working photoresist compositions are currently favored over negative working resists because the former generally have better resolution capabilities and pattern transfer characteristics. Photoresist resolution is defined as the smallest feature which the resist composition can transfer from the photomask to the substrate with a high degree of image edge acuity after exposure and development. In many manufacturing applications today, resist resolution on the order of less than one micron are necessary. In addition, it is almost always desirable that the developed photoresist wall profiles be near vertical relative to the substrate. Such demarcations between developed and undeveloped areas of the resist coating translate into accurate pattern transfer of the mask image onto the substrate. This becomes even more critical as the push toward miniaturization reduces the critical dimensions on the devices.

Positive-acting photoresists comprising novolak resins and quinone-diazide compounds as photoactive compounds are well known in the art. Novolak resins are typically produced by condensing formaldehyde and one or more multi-substituted phenols, in the presence of an acid catalyst, such as oxalic acid. Photoactive compounds are generally obtained by reacting multihydroxyphenolic compounds with naphthoquinone diazide acids or their derivatives. The sensitivity of these types of resists typically ranges from about 350nm to 440nm.

Photoresists sensitive to short wavelengths, between about 180nm and about 300nm can also be used. These resists normally comprise polyhydroxystyrene or substituted polyhydroxystyrene derivatives, a photoactive compound, and optionally a solubility inhibitor. The following references exemplify the types of photoresists used: US 4,491,628, US 5,069,997 and US 5,350,660.

The process of the instant invention further comprises coating a substrate with the novel antireflective coating and heating on a hotplate or convection oven at a sufficiently high temperature for sufficient length of time to remove the coating solvent and crosslink the polymer, if desired, to a sufficient extent so as not to be soluble in the coating solution of the photoresist or in the aqueous alkaline developer. The preferred range of temperature is from about 70°C to about 250°C. If the temperature is below 70°C then insufficient loss of solvent or insufficient degree of crosslinking takes place and at temperatures above 250°C the polymer may become chemically unstable. A film of photoresist is then coated on top of the antireflective coating and baked to substantially remove the photoresist solvent. The photoresist is imagewise exposed and developed in an aqueous developer to remove the treated resist. An optional heating step can be incorporated into the process prior to development and after exposure. The process of coating and imaging photoresists is well known to those skilled in the art and is optimized for the specific type of resist used. The patterned substrate can then be dry etched in a suitable etch chamber to remove the exposed portions of the antireflective film, with the remaining photoresist acting as an etch mask.

An intermediate layer may be placed between the antireflective coating and the photoresist to prevent intermixing, and is envisioned as lying within the scope of this invention. The intermediate layer is an inert polymer cast from a solvent, where examples of the polymer are polysulfone and polyimides.

The following specific examples will provide detailed illustrations of the methods of producing and utilizing compositions of the present invention. These examples are not intended, however, to limit or restrict the scope of the invention in any way and should not be construed as providing conditions, parameters or values which must be utilized exclusively in order to practice the present invention.

### EXAMPLE 1

### Diazonium salt formation:

4-Nitroaniline (13.8g, 0.1 mol) was charged to a jacketed 800 ml beaker at room temperature, along with 50 ml of 6 N HCl and 10 ml water. This mixture was mechanically stirred at room temperature for 20 minutes, then cooled to 0°C. To the beaker was added dropwise a pre-chilled sodium nitrite solution (7.6 g, 0.11 mol in 15 ml water). The addition was exothermic and the temperature was kept at 0-5°C. The reaction was also monitored for excess nitrite using KI paper (potassium iodide-starch test paper); the paper turned immediately dark blue / black in the presence of excess nitrite. If excess nitrite was present during the addition, the addition rate was slowed to allow time for the nitrite to react with the starting material. The addition was completed within approximately 20 to 30 minutes; excess nitrite should be present 10 minutes after the addition is completed; if not, an additional 5 to 10 mol % sodium nitrite should be added. The diazonium salt mixture was stirred for 1 hour at 0°C, after which any excess nitrite was neutralized using approximately 1 ml of a 10 wt % aqueous sulfamic acid solution. This diazonium salt solution was maintained at 0°C for the coupling reaction.

### Coupling reaction:

Ethyl acetoacetate (13 g, 12.7 ml, 0.1 mol), 35 ml pyridine, and 100 ml of deionized water was added to a pre-chilled 800 ml jacketed beaker at 0°C; mechanical stirring, thermometer, and pH probe were added. The diazonium salt solution was added dropwise over approximately 20 minutes while monitoring temperature (< 10°C) and pH. An additional 100 ml deionized water was added at end of the addition. The coupling reaction was stirred at 0°C for approximately 30 minutes. The resulting solid dye was vacuum filtered. The dye was reslurried in 5% aqueous acetic acid for 5 minutes and vacuum filtered. A final slurry in deionized water for 10 minutes was done to remove residual acetic acid, and then vacuum filtered. The dye was transferred to a crystallizing dish and dried in a vacuum oven. The UV-Vis spectrum in ethyl lactate showed a peak at 371 nm and gave an extinction coefficient of 120 ml/ g.L.

### EXAMPLE 2

### Diazonium salt formation:

4-Aminoacetanilide (15.0g, 0.1 mol) was charged to a beaker at room temperature, along with 75 ml of 6 N HCI. This mixture was magnetically stirred at room temperature for 30 minutes, then cooled to 0°C. To the beaker was added dropwise a pre-chilled sodium nitrite solution (7.6 g, 0.11 mol in 20 ml water). The addition was exothermic and the temperature was kept at < 5°C, The reaction was also monitored for excess nitrite using KI paper (potassium iodide-starch test paper); the paper turned immediately dark blue / black in the presence of excess nitrite. If excess nitrite was present during the addition, the addition rate was slowed to allow time for nitrite to react with the starting material. The addition was completed within approximately 60 minutes; excess nitrite should be present 10 minutes after the addition is completed; if not, an additional 5 to 10 mol % sodium nitrite shoul be added. The diazonium salt mixture was stirred for 1 hour at approximately 5°C, after which any excess nitrite is neutralized using approximately 1 ml of a 10 wt % aqueous sulfamic acid solution. This diazonium salt solution was maintained at approximately 0°C for the coupling reaction.

### Coupling reaction:

Ethyl acetoacetate (13.0 g, 0.1 mol), 35 ml pyridine, and 100 ml of deionized water was added to a jacketed 800 ml beaker at approximately 0°C; mechanical stirring, thermometer, and pH probe were added. The diazonium salt solution was added dropwise over approximately 60 minutes while monitoring temperature (< 10°C) and pH. The coupling reaction was stirred at approximately 0°C for approximately 1 hour. The resulting solid dye was vacuum filtered, and then washed with water on the filter cake. The material was further purified by dissolving the product in tetrahydrofuran and precipitating into twice as much hexane, and vacuum filtering. The dye was transferred to a crystallizing dish and dried in a vacuum oven. Analysis by HPLC showed the product to be 95% pure. The UV-Vis sprectrum in ethyl lactate showed a peak at 371 nm and gave an extinction coefficient of 84 ml/ g.L.

### EXAMPLE 3

### Diazonium salt formation:

Ethyl 4-aminobenzoate (16.5 g, 0.1 mol) was charged to a beaker at room temperature, along with 50 ml of 6 N HCl. This mixture was magnetically stirred at room temperature for 30 minutes, then cooled to 0°C. To the beaker was added dropwise a pre-chilled sodium nitrite solution (7.6 g, 0.11 mol in 15 ml water). The addition was exothermic and the temperature was kept at < 5° The reaction was also monitored for excess nitrite using KI paper (potassium iodide-starch test paper); the paper turned immediately dark blue / black in the presence of excess nitrite. If excess nitrite was present during the addition, the addition rate was slowed to allow time for nitrite to react with the starting material. The addition was completed within approximately 60 minutes; excess nitrite should be present 10 minutes after the addition is completed; if not, an additional 5 to 10 mol % sodium nitrite was added. The diazonium salt mixture was stirred for hour at approximately 5°C, after which any excess nitrite was neutralized using approximately 1 ml of a 10 wt % aqueous sulfamic acid solution. This diazonium salt solution was maintained at approximately 0°C for the coupling reaction.

### Coupling reaction:

Acetoacetamide (10.1 g, 0.1 mol), 35 ml of pyridine, 250 ml of deionized water, and 50 g ice was added to a 2000 ml beaker at approximately 0°C (ice / sodium chloride bath); mechanical stirring, thermometer, and pH probe were added. The diazonium salt solution was added dropwise over approximately 20 minutes while monitoring temperature (<10°C) and pH. An additional 550 ml deionized water was added at end of the addition. The coupling reaction was stirred at approximately 0°C for approximately 1 hour. The resulting solid dye was vacuum filtered. The dye was reslurried in 500ml 1 N HCl for 20 minutes and vacuum filtered. A final slurry in 500 ml deionized water for 10 minutes was formed to remove residual acid, and then vacuum filtered. The dye was transferred to a crystallizing dish and dried in a vacuum oven, yielding 24 grams. The UV-Vis spectrum in ethyl lactate showed a peak at 364.4 nm and gave an extinction coefficient of 141 ml/ g.L.

### EXAMPLE 4

### Diazonium salt formation:

Ethyl 4-aminobenzoate (16.5g, 0.1 mol) was charged to a beaker at room temperature, along with 50 ml of 6 N HCI. This mixture was magnetically stirred at room temperature for 30 minutes, then cooled to 0°C. To the beaker was added dropwise a pre-chilled sodium nitrite solution (7.6 g, 0.11 mol in 15 ml water). The addition was exothermic and the temperature was kept between approximately 0-5°C. The reaction was also monitored for excess nitrite using KI paper (potassium iodide-starch test paper); the paper turned immediately dark blue / black in the presence of excess nitrite. If excess nitrite was present during the addition, the addition rate was slowed to allow time for nitrite to react with the starting material. The addition was completed within approximately 30 minutes; excess nitrite should be present 10 minutes after the addition is completed; if not, an additional 5 to 10 mol % sodium nitrite should be added. The diazonium salt mixture was stirred for 1 hour at approximately 5°C, after which any excess nitrite was neutralized using approximately 1 ml of a 10 wt % aqueous sulfamic acid solution. This diazonium salt solution was maintained at approximately 0°C for the coupling reaction.

### Coupling reaction:

Ethyl acetoacetate (13.0 g, 0.1 mol), 35 ml of pyridine, 250 ml of deionized water, and 50 g ice was added to a 1000 ml beaker at approximately 0°C (ice / sodium chloride bath); mechanical stirring, thermometer, and pH probe were added. The diazonium salt solution was added dropwise over approximately 60 minutes while monitoring temperature (<10°C) and pH. The coupling reaction was stirred at approximately 0°C for approximately 1 hour. The resulting solid dye was vacuum filtered. The dye was reslurried in 500ml of IN HCl for 20 minutes and vacuum filtered. A final slurry in 500 ml deionized water for 10 minutes was done to remove residual acid, and then vacuum filtered. The dye was transferred to a crystallizing dish and dried in a vacuum oven, yielding 28 grams. TLC with mobile phase 2:1 ethyl acetate: hexane showed single product spot, compared with starting materials. The UV-Vis spectrum in ethyl lactate showed a peak at 355 nm and extinction coefficient of 107 ml/ g.L.

### EXAMPLE 5

### Diazonium salt formation:

Ethyl 4-aminobenzoate (57.8g, 0.35 mol) was charged to a beaker at room temperature, along with 233 ml (4 mol equivalents) of 6 N HCI. This mixture was magnetically stirred at room temperature for 30 minutes, then cooled to 0°C (with ice / sodium chloride bath). To the beaker was added dropwise a pre-chilled sodium nitrite solution (25.5 g, 0.37 mol in approximately 35 ml water). The addition was exothermic and the temperature was kept between approximately 0-5°C. The reaction was also monitored for excess nitrite using KI paper (potassium iodide-starch test paper); the paper turned immediately dark blue / black in the presence of excess nitrite. If excess nitrite was present during the addition, the addition rate was slowed to allow time for nitrite to react with the starting material. The addition was completed within approximately 30 minutes; excess nitrite should be present 10 minutes after the addition is completed; if not, an additional 5 to 10 mol % sodium nitrite should be added. The diazonium salt mixture was stirred for 1 hour at approximately 5°C, after which any excess nitrite was neutralized using approximately 1 ml of a 10 wt % aqueous sulfamic acid solution. This diazonium salt solution was maintained at approximately 0°C for the coupling reaction.

### Coupling reaction:

Allyl acetoacetate (49.8 g, 0.35 mol), 100 ml pyridine, 500 ml of deionized water was added to a beaker at approximately 0°C (ice / sodium chloride bath); mechanical stirring, thermometer, and pH probe were added. The diazonium salt solution was added dropwise over approximately 60 minutes while monitoring temperature (<10 °C) and pH. The coupling reaction was stirred at approximately 0°C for approximately 1 hour. The resulting solid dye was vacuum filtered. The dye was reslurried in 500ml 1N HCl for 20 minutes and vacuum filtered. A final slurry in 500 ml deionized water for 10 minutes was done to remove residual acid, and then vacuum filtered. The dye was transferred to a crystallizing dish and dried in a vacuum oven. The UV-Vis spectrum in ethyl lactate showed a peak at 355 nm and gave an extinction coefficient of 91 ml/ g.L.

### EXAMPLE 6-12

Table 1 shows the arylhydrazo dyes synthesized using the synthetic procedures described in Examples 1-5 and gives the peak absorption (λmax) and extinction coefficents (ε) for these dyes.

**Table I**

| **Example** | **Dye (II)** | **λmax (nm)** | **ε (ml/g.L)** |
|---|---|---|---|
| 6 | R₁ = NO₂, R₂ = OMe, R₃ = Me | 370 | 118 |
| 7 | R₁ = NO2, R₂ = OH, R₃ = Me | 383 | 108 |
| 8 | R₁ = NHCOMe, R₂ = R₃ = Me | 391 | 72 |
| 9 | R₁ = COOH, R₂ = NH₂, R₃ = Me | 371 | 144 |
| 10 | R₁ = COOH, R₂ = OEt, R₃ = Me | 353 | 106 |
| 11 | R₁ = COOEt, R₂ = OX, R₃ = Me | 355 | 79 |
| 12 | R₁ = OH, R₂ = OEt, R₃ = Me | 375 | 82 |
| X = CH₂CH₂OCOC(CH₃)CH₂ | | | |

### EXAMPLE 13

To a solution of 1.95 grams of polymethylvinylether-maleic anhydride in 27 ml of ethyl lactate (EL) was added 0.15 grams of the dye from Example 4, 0.60 grams of CYMEL® 303 (available from Cytec Industries Inc.), and 0.30 grams of p-toluenesulfonic acid monohydrate (PTSA). The solution was filtered with 0.2 µm PTFE filter, spin coated on a 4" silicon wafer to give an uniform coating, and baked on a hot plate at 150 °C for 60 seconds. The coated wafers were then immersed in PGMEA and EL for 20 seconds. After spin drying, no film dissolution was observed.

### EXAMPLE 14

To a solution of 1.95 grams of polyacrylic acid in 30 ml of methanol and 30 ml of EL was added 0 40 grams of the dye from Example 3, 0.30 grams of CYMEL® 303, and 0.20 grams of PTSA. The solution was filtered with 0.2 µm PTFE filter, spin coated on a 4" silicon wafer to give an uniform coating, and baked on a hot plate at 150°C for 60 seconds. The coated wafers were then immersed in PGMEA and EL for 20 seconds and in AZ® 300 MIF developer (available from Hoechst Celanese Corporation, 70 Meister Ave., Somerville, NJ 08876) for 40 seconds. After spin drying, no film dissolution was observed.

### EXAMPLE 15

To a solution of 2.50 grams of poly(hydroxystyrene-co-methyl methacrylate) in 50 grams of PGMEA was added 2.5 grams of the dye from Example 5, 0.50 grams of CYMEL® 303, and 0.10 grams of 2,1,4/2,1,5-diazonaphthoquinonesulfonic ester of trihydroxybenzophenone. The solution was filtered with 0.2 µm PTFE filter, spin coated on a 4" silicon wafer to give an uniform coating, and baked on a hot plate at 150 °C for 60 seconds. The coated wafers were then immersed in PGMEA and EL for 20 seconds and in AZ® 300 MIF developer (available from Hoechst Celanese Corporation, 70 Meister Ave., Somerville, NJ 08876) for 40 seconds. After spin drying no film dissolution was observed.

### EXAMPLE 16

To a solution of 2.50 grams of poly(hydroxystyrene-co-methyl methacrylate) in 50 grams of PGMEA was added 2.0 grams of the dye from Example 11, 0.50 grams of CYMEL® 303, and 0.10 grams of 2,1,4/2,1,5-diazonaphthoquinonesulfonic ester of trihydroxybenzophenone. The solution was filtered with 0.2 µm PTFE filter, spin coated on a 4" silicon wafer to give an uniform coating, and baked on a hot plate at 150°C for 60 seconds. The coated wafers were then immersed in PGMEA and EL for 20 seconds and in AZ® 300 MIF developer for 40 seconds. After spin drying, no film dissolution was observed.

### EXAMPLE 17

The sample solutions formulated in Examples 15 and 16 were tested for lithography. Each sample was spin coated on 4" aluminum wafers and soft baked on a hot plate at 150°C for 60 seconds to achieve film thickness of 0.2 µm (micrometers). AZ® 7805 (available from Hoechst Celanese Corporation , AZ Photoresist Products Division, 70 Meister Ave., Somerville, NJ 08876) was subsequently coated and baked at 90 °C for 90 seconds on these wafers to achieve resist thickness of 0.5 µm. A 4" aluminum wafer coated with 0.5 µm AZ® 7805 is used as the reference. The coated wafers were exposed on a NIKON® 0.54 NA i-line stepper with a NIKON® resolution reticle which contained various sizes of lines and spaces (L/S) pattern from 2 to 0.2 µm (micrometers). A 15x21 exposure array was printed on the wafer and then post exposure baked (PEB) on a hot plate at 110 °C for 60 seconds. The exposed wafers thus produced were spray-puddle developed with 2.38% TMAH MIF (metal ion free) developer for 35 seconds at 23°C. The minimum exposure dose required to reproduce the 0.4 µm (micrometers) line pattern at the best stepper focus was reported as the dose-to-print (DTP). The resist pattern was evaluated on a HITACHI®-S4000 SEM.

**Table 2.**

| Summary of the lithographic data for the bottom antireflective coatings | | | | | |
|---|---|---|---|---|---|
| Sample | Dye | DTP (mJ/cm²) | Resolution | DOF (0.4 µm lines) | Undercut resist pattern |
| AZ® 7805 | None | 101 | 0.38 µm | 0.6 µm | severe |
| Example 15 | Dye 5 | 160 | 0.36 µm | 1.0 µm | No |
| Example 16 | Dye 11 | 132 | 0.34 µm | 0.8 µm | slight |

As shown in Table 2, the samples formulated in Examples 15 and 16 effectively reduced resist pattern undercutting, which is an indication of better reflective notching control. The samples also showed improved resolution and DOF over the reference, AZ® 7805 on highly reflective aluminum substrate.

## Claims

1. An antireflective coating composition for use in photolithography, comprising:
a) a polymer;
b) a dye comprising a structure, 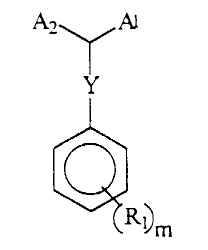 where
A₁ and A₂ are independently COR₁, CN or CNZ,
R₁ is H, (C₁-C₁₀)alkyl, (C₁-C₁₀)alkoxy, nitro, halide, cyano, aryl, alkylaryl, alkenyl, dicyanovinyl, SO₂CF₃, COOZ, SO₃Z, COZ, OZ, NZ₂, SZ, SO₂Z, NHCOZ or SO₂ NZ₂, where Z is H or (C₁-C₁₀)alkyl,
Y is a conjugated moiety N=N, CW=CW, CW=N, or N=CW, where W is H, (C₁-C₁₀)alkyl or (C₁-C₁₀)alkoxy, and m = 5; and
c) a solvent selected from the group consisting of dimethyl acetamide, dimethyl formamide, dimethyl sulfoxide, N-methyl pyrrolidone, tetrahydrofurfural alcohol, propylene glycol monomethyl ether, propylene glycol monomethyl etheracetate, ethyl lactate, heptanone, cyclopentanone, cyclohexanone, and butyrolactone.

2. An antireflective coating composition according to claim 1, wherein the dye comprises a structure, 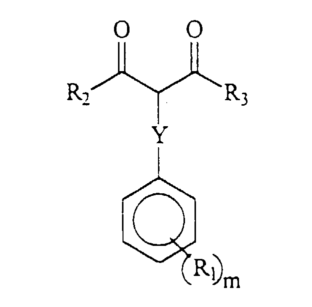 where
R₁-R₃ are independently H, (C₁-C₁₀)alkyl, (C₁-C₁₀)alkoxy, nitro, halide, cyano, aryl, alkylaryl, alkenyl, dicyanovinyl, SO₂CF₃, COOZ, SO₃Z, COZ, OZ, NZ₂, SZ, SO₂Z, NHCOZ or SO₂ NZ₂, where Z is H or (C₁-C₁₀)alkyl,
Y is a conjugated moiety N=N, CW=CW, CW=N or N=CW, where W is H, (C₁-C₁₀)alkyl or (C₁-C₁₀)alkoxy, and
m = 5.

3. An antireflective composition according to claim 1, wherein A₁ and A₂ are independently CN or CNZ, where Z is H or (C₁-C₁₀)alkyl.

4. An antireflective composition according to claim 1, wherein the polymer is selected from a group consisting of homo- and co-polymers of acrylates, amides, esters, ether, hydroxystryrene, imides, methacrylates, methyl vinyl ether-maleic anhydride, oxymethylenes, styrene, oxyalkylenes, urethanes, vinyl acetates, and vinyl ether, phenolic resins, epoxy resins, and novolak resins.

5. An antireflective composition according to claim 1, wherein the polymer is selected from a group consisting of poly(hydroxystyrene-methylmethacrylate), polyacrylic acid and poly(methylvinylethermaleic anhydride).

6. The antireflective composition according to claim 1, wherein the solvent comprises a mixture of solvents.

7. The antireflective composition according to claim 1, wherein the polymer is present in the range of about 1% to about 30% by weight of the total solution.

8. The antireflective composition according to claim 1, wherein the dye is present in the range of about 0.25% to about 20% by weight of the total solution.

9. The antireflective composition according to claim 1, further comprising a crosslinking agent.

10. The antireflective composition according to claim 1, further comprising an acid and a crosslinking agent.

11. The antireflective composition according to claim 10, further comprising a heat generated acid.

12. The antireflective composition according to claim 11, wherein the acid is a diazo naphthoquinone ester of a multihydroxybenzophenone.

13. The antireflective composition according to claim 1, wherein the metal ion level is less than 50ppb each metal ion.

14. The process of forming an image on a substrate comprising the steps of:
a) coating the substrate with the antireflective coating composition of claim 1,
b) heating the antireflective coating,
c) coating a photoresist solution on top of the antireflective coating,
d) heating the photoresist coating to substantially remove solvent from the photoresist coating,
e) imagewise exposing the photoresist coating,
f) developing an image using an aqueous alkaline developer,
g) optionally, heating the substrate prior to and after development,
h) dry etching the antireflective coating.

15. The process of claim 14, wherein the photoresist solution comprises a novolak resin, a photosensitive compound and a solvent.

16. The process of claim 14, wherein the photoresist solution comprises a substituted polyhydroxystyrene, a photoactive compound and a solvent.

17. The process of claim 14, wherein the photoresist solution comprises polyhydroxystyrene, a photoactive compound, a dissolution inhibitor and a solvent.

18. The process of claim 14, wherein the heating temperature for the antireflective coating ranges from about 70°C to about 250°C.

19. The process of claim 14, wherein the developer is an aqueous solution of metal ion free alkaline hydroxide.

## Patentansprüche

1. Reflexionsvermindernde Beschichtungszubereitung zur Verwendung in der Photolithographie, die folgende Bestandteile umfaßt:
a) ein Polymer;
b) einen Farbstoff folgender Struktur 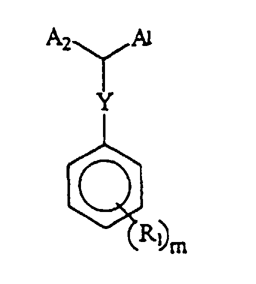 wobei A₁ und A₂ unabhängig voneinander COR₁, CN oder CNZ sind, R₁ H, (C₁-C₁₀)-Alkyl, (C₁ - C₁₀)-Alkoxy, Nitro, Halogenid, Cyano, Aryl, Alkylaryl, Alkenyl, Dicyanovinyl, SO₂CF₃, COOZ, SO₃Z, COZ, OZ, NZ₂, SZ, SO₂Z, NHCOZ oder SO₂NZ₂ ist, wobei Z für H oder (C₁ - C₁₀)-Alkyl steht, Y ein konjugierter Anteil N=N, CW=CW, CW=N oder N=CW ist, wobei W H, (C₁ - C₁₀)-Alkyl oder (C₁-C₁₀)-Alkoxy und wobei m = 5 ist, und
c) ein unter Dimethylacetamid, Dimethylformamid, Dimethylsulfoxid, N-Methylpyrrolidon, Tetrahydrofurfurolalkohol, Propylenglycolmonomethylether, Propylenglycolmonomethyletheracetat, Ethyllactat, Heptanon, Cyclopentanon, Cyclohexanon und Butyrolacton ausgewähltes Lösungsmittel.

2. Reflexionsvermindernde Beschichtungszubereitung gemäß Anspruch 1, wobei der Farbstoff folgende Struktur besitzt: 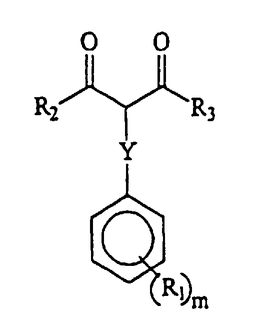 wobei R₁ - R₃ unabhängig voneinander H, (C₁ -C₁₀)-Alkyl, (C₁ - C₁₀)-Alkoxy, Nitro, Halogenid, Cyano, Aryl, Alkylaryl, Alkenyl, Dicyanovinyl, SO₂CF₃, COOZ, SO₃Z, COZ, OZ, NZ₂, SZ, SO₂Z, NHCOZ oder SO₂NZ₂ ist, wobei Z für H oder (C₁ - C₁₀)-Alkyl steht, Y ein konjugierter Anteil N=N, CW=CW, CW=N oder N=CW ist, wobei W für H, (C₁ - C₁₀)-Alkyl oder (C₁ - C₁₀)-Alkoxy und m für 5 steht.

3. Reflexionsvermindernde Zubereitung gemäß Anspruch 1, wobei A₁ und A₂ unabhängig voneinander CN oder CNZ sind und wobei Z für H oder (C₁- C₁₀)-Alkyl steht.

4. Reflexionsvermindernde Zubereitung gemäß Anspruch 1, wobei das Polymer aus einer Gruppe gewählt wird, die aus Homo- und Copolymeren von Acrylaten, Amiden, Estern, Ether, Hydroxystyrol, Imiden, Methacrylaten, Methylvinylethermaleinsäureanhydrid, Oxymethylenen, Styrol, Oxyalkylenen, Urethanen, Vinylacetaten und Vinylether, Phenolharzen, Epoxyharzen und Novolakharzen besteht.

5. Reflexionsvermindernde Zubereitung gemäß Anspruch 1, wobei das Polymer aus einer Gruppe gewählt wird, die aus Poly(hydroxystyrol-methylmethacrylat), Polyacrylsäure und Poly(methylvinylethermaleinsäureanhydrid) besteht.

6. Reflexionsvermindernde Zubereitung gemäß Anspruch 1, wobei das Lösungsmittel ein Lösungsmittelgemisch enthält.

7. Reflexionsvermindernde Zubereitung gemäß Anspruch 1, wobei das Polymer, bezogen auf die gesamte Lösung, in einer Konzentration von ca. 1 bis ca. 30 Gewichtsprozent vorliegt.

8. Reflexionsvermindernde Zubereitung gemäß Anspruch 1, wobei der Farbstoff, bezogen auf die gesamte Lösung, in einer Konzentration von ca. 0,25 bis ca. 20 Gewichtsprozent vorliegt.

9. Reflexionsvermindernde Zubereitung gemäß Anspruch 1, die zusätzlich ein Vernetzungsmittel enthält.

10. Reflexionsvermindernde Zubereitung gemäß Anspruch 1, die zusätzlich eine Säure und ein Vernetzungsmittel enthält.

11. Reflexionsvermindernde Zubereitung gemäß Anspruch 10, die zusätzlich eine durch Wärme entstandene Säure enthält.

12. Reflexionsvermindernde Zubereitung gemäß Anspruch 11, wobei die Säure ein Diazonaphthochinonester eines Multihydroxybenzophenons ist.

13. Reflexionsvermindernde Zubereitung gemäß Anspruch 1, wobei die Konzentration der Metallionen jeweils unter 50 ppb liegt.

14. Verfahren zur Herstellung einer Abbildung auf einem Träger, das aus folgenden Schritten besteht:
a) Beschichten des Trägers mit der reflexionsvermindernden Beschichtungszubereitung gemäß Anspruch 1;
b) Erwärmen der reflexionsvermindernden Beschichtung;
c) Aufbringen einer Photoresistlösung auf die reflexionsvermindernde Beschichtung;
d) Erwärmen der Photoresistbeschichtung zur weitgehenden Entfernung des Lösungsmittels aus dieser Beschichtung;
e) abbildungsgemäße Belichtung der Photoresistbeschichtung;
f) Entwicklung einer Abbildung unter Verwendung eines wäßrig-alkalischen Entwicklers;
g) wahlweise Erwärmen des Trägers vor und nach der Entwicklung;
h) Trockenätzen der reflexionsvermindernden Beschichtung.

15. Verfahren gemäß Anspruch 14, wobei die Photoresistlösung ein Novolakharz, eine lichtempfindliche Verbindung und ein Lösungsmittel enthält.

16. Verfahren gemäß Anspruch 14, wobei die Photoresistlösung ein substituiertes Polyhydroxystyrol, eine photoaktive Verbindung und ein Lösungsmittel enthält.

17. Verfahren gemäß Anspruch 14, wobei die Photoresistlösung Polyhydroxystyrol, eine photoaktive Verbindung, einen Lösungshemmer und ein Lösungsmittel enthält.

18. Verfahren gemäß Anspruch 14, wobei die reflexionsvermindernde Beschichtung bei ca. 70°C bis ca. 250°C erwärmt wird.

19. Verfahren gemäß Anspruch 14, wobei der Entwickler eine wäßrige Lösung eines metallionenfreien alkalischen Hydroxids ist.

## Revendications

1. Composition de revêtement antiréfléchissant à utiliser en photolithographie, comprenant :
a) un polymère ;
b) un colorant comprenant une structure 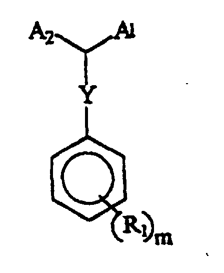
où A₁ et A₂ sont indépendamment COR₁, CN ou CNZ,
R₁ est H, un groupe alkyle en C₁-C₁₀, alcoxy en C₁-C₁₀, nitro, halogénure, cyano, aryle, alkylaryle, alcényle, dicyanovinyle, SO₂CF₃, COOZ, SO₃Z, COZ, OZ, NZ₂, SZ, SO₂Z, NHCOZ ou SO₂NZ₂, où Z est H ou un groupe alkyle en C₁-C₁₀,
Y est un fragment conjugué N=N, CW=CW, CW=N ou N=CW, où W est H, un groupe alkyle en C₁-C₁₀ ou alcoxy en C₁-C₁₀, et
m = 5 ; et
c) un solvant choisi dans le groupe formé par le diméthylacétamide, le diméthylformamide, le diméthylsulfoxyde, la N-méthylpyrrolidone, l'alcool tétrahydrofurfurylique, l'éther monométhylique de propylène-glycol, l'acétate d'éther monométhylique de propylène-glycol, le lactate d'éthyle, l'heptanone, la cyclopentanone, la cyclohexanone et la butyrolactone.

2. Composition de revêtement antiréfléchissant selon la revendication 1, dans laquelle le colorant comprend une structure 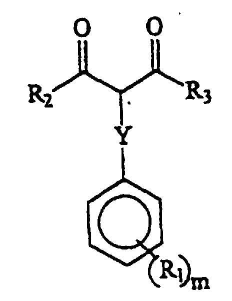
où R₁ à R₃ sont indépendamment H, un groupe alkyle en C₁-C₁₀, alcoxy en C₁-C₁₀, nitro, halogénure, cyano, aryle, alkylaryle, alcényle, dicyanovinyle, SO₂CF₃, COOZ, SO₃Z, COZ, OZ, NZ₂, SZ, SO₂Z, NHCOZ ou SO₂NZ₂, où Z est H ou un groupe alkyle en C₁-C₁₀,
Y est un fragment conjugué N=N, CW=CW, CW=N ou N=CW, où W est H, un groupe alkyle en C₁-C₁₀ ou alcoxy en C₁-C₁₀, et
m = 5.

3. Composition de revêtement antiréfléchissant selon la revendication 1, dans laquelle A₁ et A₂ sont indépendamment CN ou CNZ où Z est H ou un groupe alkyle en C₁-C₁₀.

4. Composition de revêtement antiréfléchissant selon la revendication 1, dans laquelle le polymère est choisi dans un groupe formé par les homo- et copolymères d'acrylates, amides, esters, éther, hydroxystyrène, imides, méthacrylates, éther de méthyle et de vinyle-anhydride maléique, oxyméthylènes, styrène, oxyalkylènes, uréthannes, acétates de vinyle et éther de vinyle, les résines phénoliques, les résines époxy et les résines novolaques.

5. Composition de revêtement antiréfléchissant selon la revendication 1, dans laquelle le polymère est choisi dans le groupe formé par le poly(hydroxystyrène-méthacrylate de méthyle), l'acide polyacrylique et le poly(éther de méthyle et de vinyle-anhydride maléique).

6. Composition de revêtement antiréfléchissant selon la revendication 1, dans laquelle le solvant comprend un mélange de solvants.

7. Composition de revêtement antiréfléchissant selon la revendication 1, dans laquelle le polymère est présent à raison d'environ 1 % à environ 30 % en poids par rapport au poids de la solution totale.

8. Composition de revêtement antiréfléchissant selon la revendication 1, dans laquelle le colorant est présent à raison d'environ 0,25 % à environ 20 % en poids par rapport au poids de la solution totale.

9. Composition de revêtement antiréfléchissant selon la revendication 1, comprenant de plus un agent de réticulation.

10. Composition de revêtement antiréfléchissant selon la revendication 1, comprenant de plus un acide et un agent de réticulation.

11. Composition de revêtement antiréfléchissant selon la revendication 10, comprenant de plus un acide engendré thermiquement.

12. Composition de revêtement antiréfléchissant selon la revendication 11, dans laquelle l'acide est un ester de diazonaphtoquinone d'une polyhydroxybenzophénone.

13. Composition de revêtement antiréfléchissant selon la revendication 1, dans laquelle le taux d'ions métalliques est inférieur à 50.10^{∼9} % pour chaque ion métallique.

14. Procédé de formation d'une image sur un substrat, comprenant les étapes suivantes :
a) appliquer la composition de revêtement antiréfléchissant de la revendication 1 sur le substrat,
b) chauffer le revêtement antiréfléchissant,
c) appliquer une solution de photoréserve au-dessus du revêtement antiréfléchissant,
d) chauffer la couche de réserve pour éliminer l'essentiel du solvant de la couche de photoréserve,
e) exposer la couche de photoréserve conformément à une image,
f) développer une image en utilisant un agent de développement alcalin aqueux,
g) facultativement, chauffer le substrat avant et après le développement,
h) attaquer à sec le revêtement antiréfléchissant.

15. Procédé de la revendication 14, dans lequel la solution de photoréserve comprend une résine novolaque, un composé photosensible et un solvant.

16. Procédé de la revendication 14, dans lequel la solution de photoréserve comprend un polyhydroxystyrène substitué, un composé photoactif et un solvant.

17. Procédé de la revendication 14, dans lequel la solution de photoréserve comprend du polyhydroxystyrène, un composé photoactif, un inhibiteur de dissolution et un solvant.

18. Procédé de la revendication 14, dans lequel la température de chauffage du revêtement antiréfléchissant est d'environ 70°C à environ 250°C.

19. Procédé de la revendication 14, dans lequel l'agent de développement est une solution aqueuse d'hydroxyde alcalin sans ions métalliques.
